# EUROPÄISCHE PATENTSCHRIFT

(11) **EP 3 827 516 B1**
(45) Veröffentlichungstag und Bekanntmachung des Hinweises auf die Patenterteilung: **05.10.2022**
(21) Anmeldenummer: 19769036.5
(22) Anmeldetag: 28.08.2019
(51) Int. Cl.: H02S 50/10

(54) **VERFAHREN ZUR VERWENDUNG EINER PV-EINRICHTUNG MIT VERBESSERTER GESAMTEFFIZIENZ**
METHOD TO USE A PV DEVICE HAVING IMPROVED OVERALL EFFICIENCY
PROCÉDÉ D'UTILISATION D'UNE INSTALLATION PHOTOVOLTAÏQUE AYANT UN RENDEMENT GLOBAL AMÉLIORÉ

(30) Priorität: 26.09.2018 DE 102018216485
(43) Veröffentlichungstag der Anmeldung: 02.06.2021
(73) Patentinhaber: Siemens Energy Global GmbH & Co. KG, 81739 München (DE)
(72) Erfinder: FLEISCHER, Maximilian, 85635 Höhenkirchen (DE); POHLE, Roland, 85570 Herdweg (DE); SIMON, Elfriede, 80639 München (DE); VON SICARD, Oliver, 81541 München (DE)
(86) Internationale Anmeldenummer: PCT/EP2019/072922
(87) Internationale Veröffentlichungsnummer: WO 2020/064249

(56) Entgegenhaltungen:
- WO-A1-2017/212968
- WO-A1-2018/162496
- CN-A- 107 359 860
- US-A1- 2018 248 061

## Beschreibung

Die Erfindung betrifft eine Photovoltaikeinrichtung und insbesondere die Effizienz einer solchen Das Dokument US2018/248061A beschreibt eine Photovoltaikeinrichtung.

Solare Stromerzeugung mit den Mitteln der Photovoltaik (PV) trägt aus umweltpolitischen und zunehmend auch wirtschaftlichen Gründen bspw. in Mitteleuropa einen stark steigenden Anteil zur Elektrizitätsproduktion bei. Weltweit ist bereits eine große Anzahl von PV-Anlagen installiert, die vorwiegend auf konventionellen Ansätzen mit siliziumbasierten PV-Zellen aufbauen. Seit einigen Jahren werden jedoch sog. perowskitische Materialien wie z.B. CH3NH3PbI3 (oder allgemeiner (CH3NH3)MX3-xYx (mit M=Pb oder Sn sowie X,Y=I, Br oder Cl)) hinsichtlich des Einsatzes in PV-Zellen untersucht, die aufgrund ihrer optoelektronischen Eigenschaften eine hocheffiziente Umwandlung von elektromagnetischer Strahlungsenergie in elektrische Energie erlauben. Perowskitbasierte PV-Zellen zeichnen sich zum Einen dadurch aus, dass sie vergleichsweise kostengünstig sind. Zum Anderen stellen die Perowskit-PV-Zellen eine ernstzunehmende Alternative zu den herkömmlichen siliziumbasierten PV-Zellen dar, weil sich aufgrund der in den letzten Jahren erzielten Fortschritte hinsichtlich Ihres durch die sogenannte "photo conversion efficiency" (PCE) beeinflussten Wirkungsgrades von einigen wenigen Prozent auf heutzutage über 20% andeutet, dass Wirkungsgrade bzw. Effizenzen erreichbar sind, die diejenigen der herkömmlichen PV-Zellen signifikant übertreffen. Dabei ist es denkbar, eine Perowskit-PV-Zelle allein oder aber in einem Tandem-PV-Modul bspw. in Kombination mit einer herkömmlichen Silizium-PV-Zelle zu betreiben. Letzteres wird bspw. in der PCT/EP2018/055499 beschrieben.

Trotz der vielversprechenden Entwicklung unterliegen die Perowskit-PV-Zellen jedoch dem Problem, dass ihr Wirkungsgrad nicht konstant ist. Insbesondere wurde festgestellt, dass sie ein sogenanntes Einlauf- oder auch Einschaltverhalten zeigen, das sich dadurch auszeichnet, dass die Effizienz bspw. bei Inbetriebnahme der PV-Zelle zunächst nicht dem Optimum entspricht, sondern erst nach einiger Zeit erreicht wird. Hierbei soll der Begriff "Inbetriebnahme" nicht nur die erste Inbetriebnahme nach der anfänglichen Installation der PV-Zelle umfassen, sondern auch bspw. ein Wiedereinschalten nach einer zwischenzeitlichen Deaktivierung der PV-Zelle sowie Situationen, in denen die PV-Zelle mangels Beleuchtung, bspw. nachts, keine elektrische Energie geliefert hat. Mit anderen Worten umfasst die Inbetriebnahme also allgemein den Übergang des Betriebszustands der PV-Zelle aus einem deaktiven in einen aktiven Zustand, wobei die PV-Zelle im deaktiven Zustand keine signifikante Menge an elektrischer Energie liefert. Im Gegensatz dazu stellt die PV-Zelle im aktiven Zustand in nennenswertem Umfang elektrische Energie aufgrund einer Beleuchtung einer lichtsensitiven Komponente der PV-Zelle bereit. Der Effekt, dass die optimale Effizienz der jeweiligen PV-Zelle erst nach einiger Zeit erreicht wird, wirkt sich negativ auf die Gesamteffizienz der PV-Einrichtung aus. Es ist daher eine Aufgabe der vorliegenden Erfindung, eine Möglichkeit anzugeben, eine Perowskit-PV-Zelle mit weitestgehend stabiler Effizienz zu erreichen, so dass die Gesamteffizienz verbessert ist.

Diese Aufgabe wird durch das in Anspruch 1 beschriebene Betriebsverfahren gelöst. Die Unteransprüche beschreiben vorteilhafte Ausgestaltungen. Ungeachtet des Inhalts des Rests dieser Beschreibung ist der Umfang dieser Erfindung ausschließlich so, wie er in den beigefügten Ansprüchen angegeben ist

Eine entsprechende PV-Einrichtung weist eine Perowskit-PV-Zelle zum Umwandeln von auf die Perowskit-PV-Zelle fallendem Licht L in eine elektrische Ausgangsspannung U1 auf, welche an elektrischen Anschlüssen der Perowskit-PV-Zelle abgreifbar ist. Desweiteren ist eine Kontrolleinheit zum Betreiben der PV-Einrichtung vorgesehen, wobei insbesondere zum Regeln des Betriebs der Perowskit-PV-Zelle als Teil der PV-Einrichtung faktisch eine Leistungselektronik der PV-Einrichtung geregelt wird, die der PV-Zelle zugeordnet ist und der die von der PV-Zelle bei Beleuchtung generierte elektrische Spannung U1 über eine entsprechende elektrische Leitung zugeführt wird. Die Kontrolleinheit ist nun eingerichtet, die PV-Einrichtung hinsichtlich des Eintretens einer Situation aus einer Liste von bestimmten Situationen, bspw. eine Inbetriebnahme, zu überwachen und derart zu betreiben, dass beim Eintreten der bestimmten Situation für einen vorgegebenen Zeitraum ein Vorspannungs-Betriebszustand der PV-Einrichtung ausgelöst wird, in dem eine elektrische Vorspannung aus einer Energiequelle an eine lichtsensitive Komponente der Perowskit-PV-Zelle angelegt ist. Nach Beendigung des Vorspannungs-Betriebszustandes geht die PV-Einrichtung in den normalen Betriebszustand über, in dem die Perowskit-PV-Zelle die Ausgangsspannung U1 bereit stellt.

Die Liste der bestimmten Situationen umfasst bspw. eine Inbetriebnahme der Perowskit-PV-Zelle und/oder eine mangelnde Beleuchtung der Perowskit-PV-Zelle, wobei ein Lichtsensor zum Messen einer auf die Perowskit-PV-Zelle fallenden Beleuchtung vorgesehen ist, wobei der Lichtsensor mit der Kontrolleinheit verbunden ist, um der Kontrolleinheit Sensordaten zu übermitteln, und die Kontrolleinheit eingerichtet ist, die Sensordaten auszuwerten und mit einem Beleuchtungsschwellwert zu vergleichen, wobei bei Unterschreiten des Beleuchtungsschwellwertes die vorgegebene Situation der mangelnden Beleuchtung der Perowskit-PV-Zelle vorliegt. Desweiteren kann die Liste eine Situation umfassen, in der eine die momentane Effizienz der Perowskit-PV-Zelle repräsentierende Messgröße einen vorgegebenen Effizienzschwellwert (EFFmin) der Perowskit-PV-Zelle unterschreitet. Eine derartige repräsentative Messgröße kann bspw. der sogenannte "maximum power point" der momentanen Strom-Spannungs-Kennlinie der PV-Zelle oder aber die tatsächliche, aufgrund eines Vergleichs der auf die Perowskit-PV-Zelle fallenden Strahlungsleistung mit der dementsprechend von der PV-Zelle bereit gestellten Leistung ermittelbare Effizienz sein. Weiterhin kann die Liste eine Situation umfassen, in der die momentane Ausgangsspannung U1 der Perowskit-PV-Zelle eine vorgegebene Mindestausgangsspannung Ulmin unterschreitet, wobei ein Spannungsmesser zum Messen der Ausgangsspannung U1 der Perowskit-PV-Zelle vorgesehen ist, wobei der Spannungsmesser mit der Kontrolleinheit verbunden ist, um der Kontrolleinheit Spannungsmessdaten zu übermitteln, und die Kontrolleinheit eingerichtet ist, die Spannungsmessdaten auszuwerten und mit einem Spannungsschwellwert zu vergleichen, wobei bei Unterschreiten des Spannungsschwellwertes die vorgegebene Situation des Unterschreitens der vorgegebenen Mindestausgangsspannung U1 vorliegt. Eine weitere denkbare bestimmte Situation kann ein Ablauf einer vorgegebenen Zeitspanne seit dem letzten Eintreten einer vorgegebenen Situation sein, d.h. die Vorspannung würde grundsätzlich regelmäßig bzw. periodisch angelegt. Speziell die bestimmten Situationen der Inbetriebnahme und des Ablaufs der vorgegebenen Zeitspanne seit dem letzten Eintreten einer bestimmten Situation können ohne besondere zusätzliche Hilfsmittel durch die Kontrolleinheit überwacht werden, indem diese mit einer entsprechenden Steuerungs-/Regelungssoftware ausgestattet wird, welche derartige Situationen registriert.

Es wurde erkannt, dass das Einlauf- bzw. Einschaltverhalten bei Inbetriebnahme oder in anderen, äquivalenten bestimmten Situationen mit einer Konditionierung der PV-Zelle zum Zeitpunkt der Inbetriebnahme im Zusammenhang zu stehen scheint. Es spielt demnach insbesondere eine Rolle, in welchem Zustand sich die Perowskit-PV-Zelle bspw. bei Inbetriebnahme befindet. Dieser Zustand kann erfindungsgemäß dadurch beeinflusst werden, dass an die Perowskit-PV-Zelle bzw. an deren lichtsensitive Komponente für den vorgegebenen Zeitraum, bspw. für einige wenige Sekunden, die elektrische Vorspannung angelegt wird. Dies bewirkt, dass die Effizienz nach Ablauf des vorgegebenen Zeitraums nicht wesentlich unter der optimalen Effizienz der Zelle liegt. Da die optimale Effizienz so nach einem bestimmten Zeitraum von typischweise einigen wenigen Sekunden erreicht wird, kann die Vorspannung nach dem oben erwähnten vorgegebenen Zeitraum nach Inbetriebnahme o.ä. abgeschaltet werden. Die Vorspannung kann in einer Größenordnung von bspw. 1,2V-2,0V liegen und damit relativ deutlich höher sein als die typische Betriebsspannung von etwa 0,8V.

Vorteilhafterweise repräsentiert die Leistungselektronik der PV-Einrichtung, die zumindest in einem normalen Betriebszustand der PV-Einrichtung die durch die Perowskit-PV-Zelle bei Beleuchtung mit Licht L bereit gestellte elektrische Ausgangsspannung U1 in eine an einem Ausgang der Leistungselektronik abgreifbare Ausgangsspannung U2 umwandelt, die Energiequelle. Mit anderen Worten stellt also die ohnehin vorhandene Leistungselektronik betrieben von der Kontrolleinheit die an die Perowskit-PV-Zelle anzulegende Vorspannung bereit. Zusätzliche Komponenten sind daher nicht vonnöten.

Konkret kann die Energiequelle ein Energiespeicher sein, aus dem die für das Bereitstellen der Vorspannung benötigte Energie beziehbar ist. Alternativ könnte die Energiequelle bspw. auch durch einen Anschluss an ein öffentliches oder nicht öffentliches Stromnetz realisiert sein.

Der Energiespeicher ist idealerweise in die Leistungselektronik, d.h. in die Schaltung der Leistungselektronik, integriert und insbesondere als Kondensator, bspw. als sogenannter "Supercap", oder als Batterie ausgebildet. Bspw. zeigen PCT/EP2015/061129 oder auch PCT/EP2015/061932 Leistungselektronikschaltungen mit in ihren Zwischenkreisen integrierten Energiespeichern. Auch kann hierbei ein Leistungsoptimierer eines Wechselrichters bzw. dessen integrierter Energiespeicher verwendet werden.

Die Kontrolleinheit ist nun eingerichtet, die PV-Einrichtung derart zu betreiben, dass spätestens nach dem vorgegebenen Zeitraum bzw. nach Beenden des Vorspannungs-Betriebszustandes zumindest ein Teil der von der Perowskit-PV-Zelle bei Beleuchtung mit Licht L bereit gestellten Spannung U1 zum Wiederaufladen des Energiespeichers verwendbar ist. Dies muss nicht unmittelbar nach dem vorgegebenen Zeitraum passieren, sondern kann auch bspw. erst dann von der Kontrolleinheit initialisiert werden, wenn der Energiebedarf eines von der PV-Zelle versorgten Verbrauchers niedriger ist als die von der PV-Zelle momentan zur Verfügung gestellte elektrische Energie.

Die Kontrolleinheit kann desweiteren eingerichtet sein, die PV-Einrichtung derart zu betreiben, dass die Vorspannung im Vorspannungs-Betriebszustand konstant oder gepulst an der Perowskit-PV-Zelle anliegt oder aber, dass eine vorgegebene Ladungsmenge in die Perowskit-PV-Zelle fließt. Beim gepulsten Anliegen ist eine Folge von Vorspannungs-Pulsen derart angelegt, dass zwischen zwei aufeinander folgenden Vorspannungs-Pulsen jeweils keine Vorspannung anliegt. Dabei wird zumindest zwischen einigen der Vorspannungs-Pulse, d.h. während keine Vorspannung anliegt, ein die momentane Effizienz der Perowskit-PV-Zelle repräsentierender Parameter gemessen. Für den Fall, dass die gemessene momentane Effizienz größer ist als ein vorgegebener Schwellwert wird der Vorspannungs-Betriebszustand beendet und der normale Betriebszustand ausgelöst. Dies hat den Vorteil, dass ggf. früher in den normalen Betriebszustand übergegangen werden kann.

In einem Verfahren zum Betreiben einer derartigen PV-Einrichtung wird die PV-Einrichtung hinsichtlich des Eintretens einer Situation aus einer Liste von bestimmten Situationen überwacht. Beim Eintreten einer der bestimmten Situationen wird für einen vorgegebenen Zeitraum ein Vorspannungs-Betriebszustand der PV-Einrichtung ausgelöst, in dem aus einer Energiequelle eine elektrische Vorspannung an eine lichtsensitive Komponente der Perowskit-PV-Zelle angelegt wird.

Das Betriebsverfahren sieht vor, dass die Liste von bestimmten Situationen zumindest eine Inbetriebnahme der Perowskit-PV-Zelle, eine mangelnde Beleuchtung der Perowskit-PV-Zelle, eine Situation, in der eine die momentane Effizienz der Perowskit-PV-Zelle repräsentierende Messgröße einen vorgegebenen Effizienzschwellwert (EFFmin) der Perowskit-PV-Zelle unterschreitet, eine Situation, in der die momentane Ausgangsspannung U1 der Perowskit-PV-Zelle eine vorgegebene Mindestausgangsspannung U1min unterschreitet, und/oder einen Ablauf einer vorgegebenen Zeitspanne seit dem letzten Eintreten einer bestimmten Situation umfasst.

Erfindungsgemäß wird beim Eintreten der bestimmten Situation der mangelnden Beleuchtung der Perowskit-PV-Zelle der Vorspannungs-Betriebszustand erst dann ausgelöst, wenn ein Beleuchtungsmesswert nach dem Unterschreiten des Beleuchtungsschwellwertes BS einen weiteren Beleuchtungsschwellwert BS' überschreitet. Dabei können BS und BS' identisch sein. Damit ist sichergestellt, dass der Vorspannungs-Betriebszustand erst dann ausgelöst wird, wenn vorauszusehen ist, dass die Beleuchtung für einen normalen Betrieb der Perowskit-PV-Zelle ausreicht.

Dabei wird die im Vorspannungs-Betriebszustand an die Perowskit-PV-Zelle anzulegende Vorspannung vorteilhafterweise durch eine Leistungselektronik der PV-Einrichtung bereit gestellt, so dass also die Leistungselektronik, die ohnehin zumindest in einem normalen Betriebszustand der PV-Einrichtung eine durch die Perowskit-PV-Zelle bei Beleuchtung mit Licht L bereit gestellte elektrische Spannung U1 in eine an einem Ausgang der Leistungselektronik abgreifbare Ausgangsspannung U2 umwandelt, die Energiequelle repräsentiert. Die eigentliche Energiequelle ist dabei insbesondere ein in die Leistungselektronik integrierter Energiespeicher, bspw. eine Batterie oder ein Kondensator. Generell kann die Energiequelle ein Energiespeicher sein, aus dem die für das Bereitstellen der Vorspannung benötigte Energie bezogen wird.

Nach dem vorgegebenen Zeitraum bzw. nach Beenden des Vorspannungs-Betriebszustandes wird zumindest ein Teil der von der Perowskit-PV-Zelle bei Beleuchtung mit Licht L bereit gestellten Ausgangsspannung U1 zum Wiederaufladen des Energiespeichers verwendet.

Das Betriebsverfahren sieht vor, dass die Vorspannung im Vorspannungs-Betriebszustand wie bereits erwähnt konstant oder gepulst oder derart an die Perowskit-PV-Zelle angelegt wird, dass eine vorgegebene Ladungsmenge in die Perowskit-PV-Zelle fließt. Für den Fall des gepulsten Anlegens wird eine Folge von Vorspannungs-Pulsen derart angelegt, dass zwischen zwei aufeinander folgenden Vorspannungs-Pulsen jeweils keine Vorspannung anliegt, wobei zumindest zwischen einigen der Vorspannungs-Pulse, d.h. während keine Vorspannung anliegt, ein die momentane Effizienz der Perowskit-PV-Zelle repräsentierender Parameter gemessen wird. Für den Fall, dass die gemessene momentane Effizienz größer ist als ein vorgegebener Schwellwert, wird der Vorspannungs-Betriebszustand beendet und der normale Betriebszustand ausgelöst.

Weitere Vorteile und Ausführungsformen ergeben sich aus den Zeichnungen und der entsprechenden Beschreibung.

Hinsichtlich der Ausdrücke "zum Betreiben der PV-Einrichtung" bzw. "dass die Kontrolleinheit eingerichtet ist, die PV-Einrichtung derart zu betreiben" etc., d.h. Ausdrücke, in denen die Kontrolleinheit die PV-Einrichtung bzw. eine ihrer Komponenten "betreiben" soll, sei angemerkt, dass das jeweilige Betreiben je nach Situation und Bedarf ein Regeln oder ein Steuern der jeweils betriebenen Komponente ist. Es wird davon ausgegangen, dass einem Fachmann je nach Situation und Bedarf klar sein wird, ob die Kontrolleinheit in der jeweiligen Situation bspw. steuert oder regelt.

Im Folgenden werden die Erfindung und beispielhafte Ausführungsformen anhand von Zeichnungen näher erläutert. Dort werden gleiche Komponenten in verschiedenen Figuren durch gleiche Bezugszeichen gekennzeichnet. Es ist daher möglich, dass sich bei der Beschreibung einer zweiten Figur zu einem bestimmten Bezugszeichen, welches bereits im Zusammenhang mit einer anderen, ersten Figur erläutert wurde, keine näheren Erläuterungen finden. In einem solchen Fall kann bei der Ausführungsform der zweiten Figur davon ausgegangen werden, dass die dort mit diesem Bezugszeichen gekennzeichnete Komponente auch ohne nähere Erläuterung im Zusammenhang mit der zweiten Figur die gleichen Eigenschaften und Funktionalitäten aufweist, wie im Zusammenhang mit der ersten Figur erläutert. Desweiteren werden der Übersichtlichkeit wegen teilweise nicht sämtliche Bezugszeichen in sämtlichen Figuren dargestellt, sondern nur diejenigen, auf die in der Beschreibung der jeweiligen Figur Bezug genommen wird.

Es zeigen:
- FIG 1: eine Perowskit-PV-Zelle,
- FIG 2: eine PV-Einrichtung.

Zur Begriffsklärung sei vorweg angemerkt, dass sich Begriffe wie "oben", "unten", "über", "auf", "unter" etc. im jeweiligen Zusammenhang auf ein Koordinatensystem beziehen, bei dem sich die Quelle des durch die PV-Zelle in elektrische Spannung umzuwandelnden Lichts, d.h. bspw. die Sonne, "oben" bzw. "über" der PV-Zelle befindet.

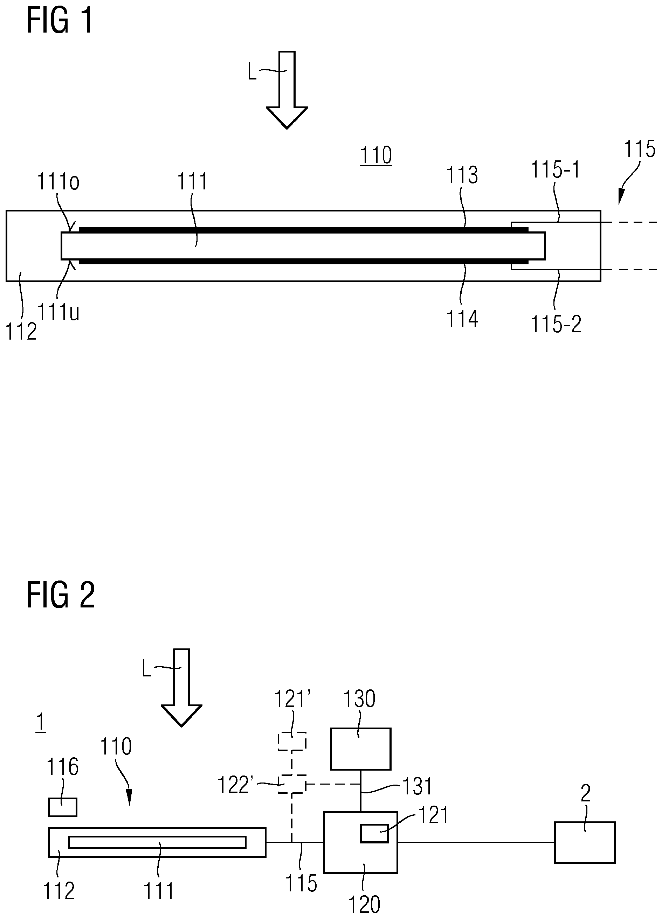

Die FIG 1 zeigt exemplarisch und vereinfacht eine PV-Zelle 110. Die PV-Zelle 110 weist eine lichtsensitive Komponente 111 auf, welche in einem Träger 112, bpsw. Glas, eingebettet ist. Die lichtsensitive Komponente 111, welche bei Bestrahlung mit Licht L eine elektrische Spannung U1 bereit stellt, welche also das auf die Perowskit-PV-Zelle 110 fallende Licht L in eine elektrische Ausgangsspannung U1 wandelt, besteht im Wesentlichen aus einem perowskitischen Material wie es eingangs beschrieben wurde, weswegen die PV-Zelle 110 im Folgenden auch als "Perowskit-PV-Zelle" bezeichnet wird. In der Praxis besteht die lichtsensitive Komponente 111 aus mehreren Schichten, insbesondere einschließlich einer wesentlichen Schicht aus dem perowskitischen Material, wobei jedoch im hier diskutierten Zusammenhang der exakte Schichtaufbau der PV-Zelle 110 keine wesentliche Rolle spielt und dementsprechend nicht näher erläutert wird. Die generelle Arbeitsweise einer PV-Zelle und insbesondere diejenige einer lichtsensitiven Komponente sind desweiteren ausreichend bekannt und werden daher im Folgenden ebenfalls nicht näher erläutert. Es wird lediglich erwähnt, dass die in der lichtsensitiven Komponente 111 aufgrund der Bestrahlung mit Licht L generierte elektrische Ausgangsspannung U1 an Elektroden 113, 114 der PV-Zelle abgegriffen werden kann. Die Elektroden 113, 114 erstrecken sich in der Praxis typischerweise über die gesamte obere bzw. untere Oberfläche 111o, 111u der lichtsensitiven Komponente 111. Dabei ist die Elektrode 113 an der dem Licht L bzw. der entsprechenden, nicht eigens dargestellten Lichtquelle zugewandten Oberfläche 111o der lichtsensitiven Komponente 111 zumindest transparent für denjenigen Teil des Spektrums des Lichts L, für den die lichtsensitive Komponente 111 ihre Maximaleffizienz aufweist. Dieses somit teiltransparente Material kann bspw. mit Li-TFSI dotiertes Spiro-OMeTAD sein. Die Elektrode 114 an der unteren Oberfläche 111u der lichtsensitiven Komponente 111 muss dagegen nicht transparent sein und kann bspw. aus Gold bestehen. Die Perowskit-PV-Zelle 110 weist desweiteren einen elektrischen Anschluss 115 mit Leitungen 115-1, 115-2 auf, mit der die PV-Zelle 110, wie in der FIG 2 angedeutet, mit einer Leistungselektronik 120 verbindbar ist, um der Leistungselektronik 120 die bei Beleuchtung generierte Spannung U1 zur Verfügung zu stellen. Die Leistungselektronik 120 ist typischerweise als Wechselrichter ausgebildet, der die von der Perowskit-PV-Zelle 110 bereit gestellte Gleichspannung U1 in eine für einen Verbraucher 2 geeignete Wechselspannung U2 wandelt.

Die FIG 2 zeigt exemplarisch und vereinfacht eine PV-Einrichtung 1 mit einer Perowskit-PV-Zelle 110 wie in der FIG 1 erläutert sowie mit der bereits erwähnten Leistungselektronik 120. Die PV-Einrichtung 1 umfasst desweiteren eine Kontrolleinheit 130, welche eingerichtet ist, die PV-Einrichtung 1 je nach gewünschter bzw. benötigter Betriebsart zu betreiben. Dabei wird insbesondere zum Regeln des Betriebs der Perowskit-PV-Zelle 110 als Teil der PV-Einrichtung 1 faktisch die Leistungselektronik 120 geregelt, die zum Einen über eine Datenverbindung 131 mit der Kontrolleinheit 130 verbunden ist. Zum Anderen ist die Leistungselektronik 120 der PV-Zelle 110 zugeordnet, und die von der PV-Zelle 110 bei Beleuchtung generierte elektrische Spannung U1 wird der Leistungselektronik 120 über die elektrische Leitung bzw. den Anschluss 115 zugeführt.

Die Kontrolleinheit 130 unterscheidet insbesondere zwischen einen normalen Betriebszustand bzw. "Normalbetrieb" und einem Vorspannungs-Betriebszustand. Im Normalbetrieb der PV-Einrichtung 1 wird die Perowskit-PV-Zelle 110 mit Licht L beleuchtet und generiert die Ausgangsspannung U1. Diese wird der Leistungselektronik 120 zugeführt und dort je nach Bedarf und betrieben durch die Kontrolleinheit 130 in eine elektrische Spannung U2 gewandelt, die schließlich dem elektrischen Verbraucher 2 zur Verfügung gestellt wird. Während des Normalbetriebes arbeitet die PV-Einrichtung 1 und insbesondere die Perowskit-PV-Zelle 110 bei normaler Effizienz EFF(t)=EFFnorm, die idealerweise der maximal erreichbaren Effizienz EFFmax entspricht. Wie einleitend erläutert wurde, vergeht jedoch nach einem Zeitraum mit fehlender oder höchstens sehr schwacher Beleuchtung, bspw. nach einer Inbetriebnahme der PV-Zelle 110 zu einem Zeitpunkt T0, zunächst ein gewisser Zeitraum, bis die Effizienz EFF zu einem Zeitpunkt T1 die normale Effizienz EFFnorm erreicht. Im Wesentlichen gilt also EFF(t')<EFFnorm für einen Zeitraum T0≤t'T1, während für t>T1 gilt EFF(t)=EFFnorm.

Mit anderen Worten und insbesondere verallgemeinert ist also die Effizienz EFF der Perowskit-PV-Zelle 110 beim Eintreten einer bestimmten Situation, im genannten Beispiel bei einer Inbetriebnahme, und noch für einen gewissen Zeitraum danach geringer als die im Normalbetrieb erwartbare Effizienz EFFnorm.

Die Kontrolleinheit 130 ist nun eingerichtet, die PV-Einrichtung 1 hinsichtlich des Eintretens einer solchen bestimmten Situation zu überwachen und derart zu betreiben, dass beim Eintreten der bestimmten Situation für einen vorgegebenen Zeitraum dT, der typischerweise einige Sekunden andauern wird, der Vorspannungs-Betriebszustand der PV-Einrichtung 1 ausgelöst wird. Im Vorspannungs-Betriebszustand wird aus einer Energiequelle 121 an die Perowskit-PV-Zelle 110 bzw. an deren lichtsensitive Komponente 111 und insbesondere über die Elektroden 113, 114 eine elektrische Vorspannung in einer Größenordnung von bspw. 1,2V-2,0V angelegt. Die Vorspannung induziert eine Ionenwanderung innerhalb der lichtsensitiven Komponente 111, was den Aufbau eines elektrischen Feldes bewirkt, welches sich positiv auf die Effizienz EFF(t) auswirkt, insbesondere wenn die normale Effizienz EFFnorm noch nicht erreicht ist.

Mit dem Abschalten der Vorspannung endet auch der Vorspannungs-Betriebszustand und die PV-Einrichtung 1 geht in den Normalbetrieb über, in dem die Perowskit-PV-Zelle 110 eine Ausgangsspannung U1 bereit stellt, die in bekannter Weise der Leistungselektronik 120 zur weiteren Verarbeitung zugeführt wird, und in dem die PV-Einrichtung 1 insbesondere mit normaler Effizienz EFFnorm und mit normaler Effizienz arbeitet.

Die Energiequelle 121 ist idealerweise in die ohnehin vorhandene Leistungselektronik 120 integriert. Dabei ist der Ausdruck "integriert" so zu verstehen, dass die Energiequelle 121 nicht nur bspw. in einem Gehäuse der Leistungselektronik 120 untergebracht ist. Vielmehr meint "integriert", dass die Energiequelle 121, die in diesem Fall insbesondere als Batterie oder als Kondensator ausgebildet ist, schaltungstechnisch in die Schaltung der Leistungselektronik 120 integriert ist. Besonders vorteilhaft kann die Energiequelle 121 eine in der Schaltung der Leistungselektronik 120 ohnehin vorgesehene Komponente sein. Wie bereits oben erwähnt zeigen PCT/EP2015/061129 sowie auch PCT/EP2015/061932 Leistungselektronikschaltungen mit in ihren Zwischenkreisen integrierten Energiespeichern.

Die Energiequelle 121 kann alternativ zur Integration in die Leistungselektronik 120 natürlich auch eine separate, außerhalb und unabhängig von der Leistungselektronik 120 arrangierte Energiequelle 121' sein, bspw. eine Batterie oder auch ein Anschluss an ein öffentliches oder nicht öffentliches Stromnetz. Dies ist in FIG 2 durch die mit gestrichelten Linien angedeutete Energiequelle 121' demonstriert, die bspw. über die elektrische Verbindung bzw. den Anschluss 115 und die entsprechenden Elektroden 113, 114 mit der lichtsensitiven Komponente 111 verbunden sein kann. Alternativ könnte die Energiequelle 121' natürlich auch über eine separate, zusätzliche Verbindung mit den Elektroden 113, 114 der lichtsensitiven Komponente 111 verbunden sein. Dies ist jedoch insofern weniger vorteilhaft, als dass in diesem Fall zusätzlicher Aufwand hinsichtlich der entsprechenden Verkabelung und Kontaktierung notwendig würde. Je nach Art der separaten Energiequelle 121' ist ggf. eine Elektronik 122' notwendig, die die bspw. vom Stromnetz 121' zur Verfügung gestellte elektrische Wechselspannung in die benötigte Vorspannung wandelt. Hier würde die Elektronik 122', die im geschilderten Fall als Gleichrichter ausgebildet wäre, von der Kontrolleinheit 130 entsprechend betrieben werden.

Die Integration der Energiequelle 121 in die Leistungselektronik 120 bringt jedoch gegenüber der Verwendung einer separaten Energiequelle 121' den wesentlichen Vorteil mit sich, dass die ohnehin vorhandene Datenverbindung 131 zwischen der Kontrolleinheit 130 und der Leistungselektronik 120 genutzt werden kann, um die Energiequelle 121 in der Leistungselektronik 120 direkt derart zu betreiben, dass sie in den bestimmten Situationen die benötigte Vorspannung liefert. Besonders vorteilhaft ist die Nutzung einer in der elektronischen Schaltung der Leistungselektronik 120 bereits vorhandenen Energiequelle. Derartige moderne Leistungselektroniken 120 sind häufig mit sogenannten "Leistungsoptimierern" (engl. "power optimizer") verbunden bzw. umfassen diese, welche elektrisch mit dem Wechselrichter 120 gekoppelt sind und eine als Energiequelle einsetzbare Komponente aufweisen bzw. selbst als solche fungieren können. Diese Komponente der elektronischen Schaltung der Leistungselektronik 120 kann in der hier beschriebenen Anwendung als Quelle 121 elektrischer Energie zum Bereitstellen der Vorspannung an den Elektroden 113, 114 verwendet werden, wobei die entsprechend notwendige Steuerung bzw. Regelung seitens der Kontrolleinheit 130 geleistet wird. Im beschriebenen Fall muss die Leistungselektronik 120 somit nicht verändert werden, sondern es wird auf die verfügbare elektronische Schaltung zurück gegriffen.

Im Betrieb der PV-Einrichtung 1 arbeitet die Kontrolleinheit 130 derart, dass sie die PV-Einrichtung 1 spätestens nach dem vorgegebenen Zeitraum dT, in dem sich die PV-Einrichtung 1 im Vorspannungs-Betriebszustand befindet, wieder in den normalen Betriebszustand versetzt, so dass sie im Normalbetrieb arbeitet. Vorteilhafterweise wird nun im Normalbetrieb zumindest ein Teil der Ausgangsspannung U1, die die Perowskit-PV-Zelle 110 im Normalbetrieb generiert, zum Wiederaufladen des Energiespeichers 121 verwendet. Dies muss nicht unmittelbar nach dem vorgegebenen Zeitraum dT passieren, sondern kann auch bspw. erst dann von der Kontrolleinheit 130 initialisiert werden, wenn der Energiebedarf des von der PV-Einrichtung 1 versorgten Verbrauchers 2 niedriger ist als die von der PV-Zelle 110 momentan zur Verfügung gestellte elektrische Energie.

Die Kontrolleinheit 130 ist desweiteren eingerichtet, die PV-Einrichtung 1 und für den Fall, dass die Energiequelle 121 in die Leistungselektronik 120 integriert ist, insbesondere die Leistungselektronik 120 derart zu betreiben, dass die Vorspannung während des vorgegebenen Zeitraums dT konstant an der lichtsensitiven Komponente 111 der Perowskit-PV-Zelle 110 bzw. an den entsprechenden Elektroden 113, 114 anliegt.

In einer ersten Alternative hierzu kann die Kontrolleinheit 130 auch derart arbeiten, dass die Vorspannung gepulst anliegt. Dabei wird eine Zeitserie von Vorspannungs-Pulsen an die Elektroden 113, 114 angelegt, wobei zwischen zwei aufeinander folgenden Pulsen keine Spannung an den Elektroden 113, 114 anliegt. In diesem Fall kann jeweils zwischen zwei Vorspannungs-Pulsen ggf. eine Messung bspw. des Wirkungsgrades oder der Strom-Spannungs-Kennlinie oder einer anderen, die momentane Effizienz der Perowskit-PV-Zelle 110 repräsentierenden Größe erfolgen. Wenn diese Messung ergibt, dass die gemessene Effizienz EFF(t) einen vorgebbaren Schwellwert erreicht, der bspw. im Wesentlichen der normalen Effizienz EFFnorm entspricht, kann der Vorspannungs-Betriebszustand ggf. frühzeitig beendet werden, d.h. vor Ablauf des vorgegebenen Zeitraums dT.

In einer zweiten Alternative ist die Vorspannung derart angelegt, dass eine vorgegebene Ladungsmenge in die Perowskit-PV-Zelle 110 bzw. in die lichtsensitive Komponente 111 fließt. Da wie einleitend erwähnt davon auszugehen ist, dass die Ionenwanderung in der lichtsensitiven Komponente 111 eine wesentliche Rolle bei der anfangs verminderten Effizienz und bei der vorteilhaften Wirkung der Vorspannung spielt, erlaubt die Kontrolle der im Vorspannungs-Betriebszustand in die lichtsensitive Komponente 111 fließenden Ladung eine noch genauere Einstellung der Arbeitsbedingungen der PV-Zelle 110 als im Fall des Anlegens der konstanten Vorspannung.

Im oben genannten Beispiel ist die bestimmte Situation, deren Eintreten die Voraussetzung für das Auslösen des Vorspannungs-Betriebszustandes der PV-Einrichtung 1 ist, eine Inbetriebnahme der PV-Einrichtung 1 wie sie einleitend definiert wurde. Bei einer solchen Inbetriebnahme ist die Kontrolleinheit 130 typischerweise direkt involviert, da eine Inbetriebnahme in der Regel über die Kontrolleinheit 130 selbst ausgelöst wird. Dementsprechend ist die Überwachung hinsichtlich des Eintretens dieser bestimmten Situation sowie das ggf. anschließende Einleiten der Maßnahme des Anlegens der Vorspannung wenig aufwändig und im einfachsten Fall durch reine Softwarelösungen der Betriebssoftware der Kontrolleinheit 130 umsetzbar.

Die bestimmte Situation der Inbetriebnahme ist jedoch nicht die einzige Situation, in der die PV-Einrichtung 1 in den Vorspannungs-Betriebszustand übergeht, so dass eine elektrische Vorspannung an die Perowskit-PV-Zelle 110 angelegt ist. Als bestimmte Situation, deren Eintreten die Voraussetzung für das Auslösen des Vorspannungs-Betriebszustandes der PV-Einrichtung 1 ist, kann in einer ersten Weiterbildung auch eine mangelnde Beleuchtung der Perowskit-PV-Zelle 110 bspw. aufgrund von Bewölkung oder im Falle der morgendlichen oder abendlichen Dämmerung o.ä. in Frage kommen. Um die PV-Einrichtung 1 hinsichtlich des Eintretens einer solchen bestimmten Situation der mangelnden Beleuchtung zu überwachen, weist die PV-Einrichtung 1 einen Lichtsensor 116 auf, der möglichst nah an der lichtsensitiven Komponente 111 der Perowskit-PV-Zelle 110 angeordnet und der zudem mit der Kontrolleinheit 130 verbunden ist, um der Kontrolleinheit 130 Sensordaten zu übermitteln. Die Sensordaten sind ein Maß für die Stärke der Beleuchtung der Perowskit-PV-Zelle 110 und die Kontrolleinheit 130 ist eingerichtet, die Sensordaten auszuwerten und mit einem Beleuchtungsschwellwert BS zu vergleichen. Bei Unterschreiten des Beleuchtungsschwellwertes BS ist davon auszugehen, dass die bestimmte Situation der mangelnden Beleuchtung der Perowskit-PV-Zelle 110 vorliegt und die Kontrolleinheit 130 kann, wie im Fall der Inbetriebnahme, für den Zeitraum dT den Vorspannungs-Betriebszustand auslösen. Das Auslösen des Vorspannungs-Betriebszustands erfolgt in einer vorteilhaften Weiterbildung allerdings insbesondere erst dann, wenn die momentane, vom Lichtsensor 116 gemessene Beleuchtung einen vorgegebenen Beleuchtungsschwellwert BS' überschreitet, da die Beleuchtung ansonsten für einen Normalbetrieb nicht ausreichen würde und das Anlegen der Vorspannung überflüssig wäre, da die Perowskit-PV-Zelle 110 ohnehin nicht effizient arbeiten würde. Dabei kann ggf. gelten BS=BS'. In der bestimmten Situation der mangelnden Beleuchtung werden also idealerweise zwei Zeitpunkte TS1, TS2 betrachtet, nämlich derjenige Zeitpunkt TS1, zu dem der Beleuchtungsschwellwert BS unterschritten wird, und derjenige Zeitpunkt TS2, zu dem der Beleuchtungsschwellwert BS' überschritten wird. Beim Feststellen des Unterschreitens des ersten Beleuchtungsschwellwertes BS kann die Kontrolleinheit 130 zunächst in einen Stand-By-Betrieb und erst beim anschließenden Überschreiten des Beleuchtungsschwellwertes BS' aus dem Stand-By-Betrieb in den Vorspannungs-Betriebszustand übergehen. Das weitere Verfahren läuft dann, wenn der Vorspannungs-Betriebszustand ausgelöst ist, wie oben bereits beschrieben ab, d.h. die Vorspannung und mit ihr der Vorspannungs-Betriebszustand wird nach dem Zeitraum dT beendet oder, im Fall des gepulsten Anlegens der Vorspannung, ggf. wenn die gemessene Effizienz EFF(t) den vorgebbaren Schwellwert erreicht.

Als bestimmte Situation, deren Eintreten die Voraussetzung für das Auslösen des Vorspannungs-Betriebszustandes der PV-Einrichtung 1 ist, kann in einer zweiten Weiterbildung auch ein Unterschreiten einer vorgegebenen Mindesteffizienz EFFmin der Perowskit-PV-Zelle 110 in Frage kommen. Dabei wird eine die momentane Effizienz der Perowskit-PV-Zelle 110 repräsentierender Messgröße ermittelt und mit einem Effizienzschwellwert verglichen. Möglichkeiten zur Messung einer solchen, die momentane Effizienz repräsentierenden Messgröße werden unten angegeben. Vergleichbar mit der ersten Weiterbildung wird auch in der zweiten Weiterbildung die Kontrolleinheit 130 eingesetzt, um die momentane Effizienz bzw. die entsprechende repräsentierende Messgröße zu überwachen. Bei Unterschreiten des Effizienzschwellwertes ist davon auszugehen, dass die bestimmte Situation der zu geringen momentanen Effizienz der Perowskit-PV-Zelle 110 vorliegt, und die Kontrolleinheit 130 löst für den Zeitraum dT den Vorspannungs-Betriebszustand aus. Das weitere Verfahren läuft dann, wenn der Vorspannungs-Betriebszustand ausgelöst ist, wie oben bereits beschrieben ab.

In ähnlicher Weise kann in einer dritten Weiterbildung ein Unterschreiten einer vorgegebenen Mindestausgangsspannung U1min der Perowskit-PV-Zelle 110 als bestimmte Situation, deren Eintreten die Voraussetzung für das Auslösen des Vorspannungs-Betriebszustandes der PV-Einrichtung 1 ist, in Frage kommen. Die momentane Ausgangsspannung U1 der Perowskit-PV-Zelle 110 liegt an der Leistungselektronik 120 an und es kann davon ausgegangen werde, dass die Spannung U1 auch der Kontrolleinheit 130 vorliegt. Allgemein kann dies so ausgedrückt werden, dass die PV-Einrichtung 1 einen Spannungsmesser zum Messen der Ausgangsspannung U1 der Perowskit-PV-Zelle 110 aufweist, wobei der Spannungsmesser faktisch durch die Leistungselektronik 120 in Kombination mit der Kontrolleinheit 130 realisiert ist. Der Spannungsmesser 120 ist mit der Kontrolleinheit 130 verbunden, um Spannungsmessdaten zu übermitteln, die die momentane Ausgangsspannung U1 repräsentieren, und die Kontrolleinheit 130 ist eingerichtet, die Spannungsmessdaten auszuwerten und mit einem Spannungsschwellwert zu vergleichen. Bei Unterschreiten des Spannungsschwellwertes liegt die bestimmte Situation des Unterschreitens der vorgegebenen Mindestausgangsspannung U1min vor und die Kontrolleinheit 130 löst den Vorspannungs-Betriebszustand aus. Das weitere Verfahren läuft dann, wenn der Vorspannungs-Betriebszustand ausgelöst ist, wie oben bereits beschrieben ab.

In einer vierten Weiterbildung kann das Ablaufen einer bestimmten Zeitspanne seit dem letzten Eintreten einer bestimmten Situation wiederum als bestimmte Situation angesehen werden, d.h. die bestimmte Situation und mit ihr der Vorspannungs-Betriebszustand würden grundsätzlich regelmäßig bzw. periodisch eintreten. Das weitere Verfahren läuft dann, wenn der Vorspannungs-Betriebszustand ausgelöst ist, wie oben bereits beschrieben ab. Speziell die bestimmte Situationen des Ablaufs der vorgegebenen Zeitspanne seit dem letzten Eintreten einer bestimmten Situation kann, wie diejenige der Inbetriebnahme, ohne besondere zusätzliche Hilfsmittel durch die Kontrolleinheit 130 überwacht werden, indem diese mit einer entsprechenden Softwarelösung der Betriebssoftware ausgestattet wird, welche derartige Situationen registriert. Abschließend sei erwähnt, dass ein Weg zur Messung der momentanen Effizienz der Perowskit-PV-Zelle 110 bzw. zur Ermittlung einer die momentane Effizienz repräsentierenden Messgröße darin besteht, eine auf die PV-Zelle 110 fallende Lichtmenge bzw. Bestrahlungsstärke in Form einer entsprechenden Leistung zu messen und diese mit der durch die PV-Zelle 110 aufgrund dieser Bestrahlung produzierten Leistung zu vergleichen. Eine weitere Möglichkeit zur Ermittlung einer die momentane Effizienz der Perowskit-PV-Zelle 110 repräsentierenden Messgröße ist die Bestimmung des momentanen, sogenannten "Maximum Power Point" (MPP) der Strom-Spannungs-Kennlinie der Perowskit-PV-Zelle 110, der denjenigen Punkt auf der Strom-Spannungs-Kennlinie beschreibt, an dem die PV-Zelle 110 bei den jeweils gegebenen Umgebungsbedingungen die maximal mögliche Leistung zur Verfügung stellt. Es kann also bspw. zu einem Zeitpunkt Tx eine momentane Strom-Spannungs-Kennlinie aufgenommen und darin der momentane MPP(Tx) bestimmt werden, der dann ein Maß für die momentane Effizienz ist. Wenn dieser MPP(Tx) kleiner ist als der als bekannt angenommene MPP(norm), welcher die maximal mögliche Leistung bei normal bzw. optimal arbeitender PV-Zelle 110 beschreibt, muss davon ausgegangen werden, dass die momentane Effizienz geringer ist als im normalen Betrieb üblich bzw. möglich. Hierbei kommt es konsequenterweise nicht auf den Absolutwert MPP(Tx) an, sondern auf den Vergleich mit einem Referenzwert, bspw. MPP(norm).

Weiterhin sei angemerkt, dass die "photon conversion efficiency" PCE der lichtsensitiven Komponente 111 der Perowskit-PV-Zelle 110 oben als Maß für die Effizienz bzw. für den Wirkungsgrad der Perowskit-PV-Zelle 110 angenommen werden kann, auch wenn davon auszugehen ist, dass die Effizienz der PV-Zelle 110 nicht allein von der PCE abhängt, sondern auch von anderen, teilweise fixen Parametern wie bspw. der Art bzw. dem Material der Elektroden 113, 114, der Anordnung der Elektroden 113, 114 sowie eventuellen weiteren Schichten der lichtsensitiven Komponente 111, die hier nicht erwähnt wurden. Es wird jedoch auch angenommen, dass die hier applizierte Vorspannung im Wesentlichen auf die PCE wirkt und nicht auf die anderen, die Effizienz beeinflussenden Parameter. Daher ist der Ansatz, dass der die Effizienz im Wesentlichen von der PCE repräsentiert wird, an dieser Stelle vertretbar.

### Bezugszeichen

- 1: PV-Einrichtung
- 110: Perowskit-PV-Zelle
- 111: lichtsensitive Komponente
- 111o: obere Oberfläche
- 111u: untere Oberfläche
- 112: Träger
- 113: Elektrode
- 114: Elektrode
- 115: elektrischer Anschluss, Verbindung

- 115-1: elektrische Leitung
- 115-2: elektrische Leitung

- 116: Lichtsensor
- 120: Leistungselektronik
- 121: Energiequelle, Batterie, Kondensator, Supercap
- 121': Energiequelle, Stromnetz
- 122': Elektronik
- 130: Kontrolleinheit
- 131: Datenverbindung

## Patentansprüche

1. Verfahren zum Betreiben einer PV-Einrichtung (1) mit
- einer Perowskit-PV-Zelle (110) zum Umwandeln von auf die Perowskit-PV-Zelle (110) fallendem Licht L in eine elektrische Ausgangsspannung U1, welche an einem elektrischen Anschluss (115) der Perowskit-PV-Zelle abgreifbar ist, sowie
- einer Kontrolleinheit (130) zum Betreiben der PV-Einrichtung (1),
wobei
- die Kontrolleinheit (130) eingerichtet ist, die PV-Einrichtung (1) hinsichtlich des Eintretens einer Situation aus einer Liste von bestimmten Situationen zu überwachen und derart zu betreiben, dass beim Eintreten der bestimmten Situation für einen vorgegebenen Zeitraum ein Vorspannungs-Betriebszustand der PV-Einrichtung (1) ausgelöst wird, in dem eine elektrische Vorspannung aus einer Energiequelle (121, 121') an eine lichtsensitive Komponente (111) der Perowskit-PV-Zelle (110) angelegt ist,
wobei die Liste von bestimmten Situationen umfasst:
- eine Inbetriebnahme der Perowskit-PV-Zelle (110) und/oder
- eine mangelnde Beleuchtung der Perowskit-PV-Zelle (110), wobei ein Lichtsensor (116) zum Messen einer auf die Perowskit-PV-Zelle (110) fallenden Beleuchtung vorgesehen ist, wobei der Lichtsensor (116) mit der Kontrolleinheit (130) verbunden ist, um der Kontrolleinheit (130) Sensordaten zu übermitteln, und die Kontrolleinheit (130) eingerichtet ist, die Sensordaten auszuwerten und mit einem Beleuchtungsschwellwert zu vergleichen, wobei bei Unterschreiten des Beleuchtungsschwellwertes die bestimmte Situation der mangelnden Beleuchtung der Perowskit-PV-Zelle (110) vorliegt, und/oder
- eine Situation, in der eine die momentane Effizienz der Perowskit-PV-Zelle (110) repräsentierende Messgröße einen vorgegebenen Effizienzschwellwert der Perowskit-PV-Zelle (110) unterschreitet, und/oder
- eine Situation, in der die momentane Ausgangsspannung U1 der Perowskit-PV-Zelle (110) eine vorgegebene Mindestausgangsspannung U1min unterschreitet, wobei ein Spannungsmesser (120) zum Messen der Ausgangsspannung U1 der Perowskit-PV-Zelle (110) vorgesehen ist, wobei der Spannungsmesser (120) mit der Kontrolleinheit (130) verbunden ist, um der Kontrolleinheit (130) Spannungsmessdaten zu übermitteln, und die Kontrolleinheit (130) eingerichtet ist, die Spannungsmessdaten auszuwerten und mit einem Spannungsschwellwert zu vergleichen, wobei bei Unterschreiten des Spannungsschwellwertes die bestimmte Situation des Unterschreitens der vorgegebenen Mindestausgangsspannung U1 vorliegt, und/oder
- einen Ablauf einer vorgegebenen Zeitspanne seit dem letzten Eintreten einer bestimmten Situation,
**dadurch gekennzeichnet, dass** die Kontrolleinheit (130) eingerichtet ist, die PV-Einrichtung (1) derart zu betreiben, dass beim Eintreten der bestimmten Situation der mangelnden Beleuchtung der Perowskit-PV-Zelle (110) der Vorspannungs-Betriebszustand erst dann ausgelöst wird, wenn der Beleuchtungsmesswert nach dem Unterschreiten des Beleuchtungsschwellwertes BS einen weiteren Beleuchtungsschwellwert BS' überschreitet.

2. Verfahren nach Anspruch 1, **dadurch gekennzeichnet, dass** eine Leistungselektronik (120) der PV-Einrichtung (1), die zumindest in einem normalen Betriebszustand der PV-Einrichtung (1) die durch die Perowskit-PV-Zelle (110) bei Beleuchtung mit Licht L bereit gestellte elektrische Ausgangsspannung U1 in eine an einem Ausgang der Leistungselektronik (120) abgreifbare Ausgangsspannung U2 umwandelt, die Energiequelle (121, 121') repräsentiert.

3. Verfahren nach einem der Ansprüche 1 oder 2, **dadurch gekennzeichnet, dass** die Energiequelle (121, 121') ein Energiespeicher ist, aus dem die für das Bereitstellen der Vorspannung benötigte Energie bezogen wird.

4. Verfahren nach Anspruch 2 und 3, **dadurch gekennzeichnet, dass** der Energiespeicher (121) in die Leistungselektronik (120) integriert und insbesondere als Kondensator oder als Batterie ausgebildet ist.

5. Verfahren nach einem der vorhergehenden Ansprüche, **dadurch gekennzeichnet, dass** die im Vorspannungs-Betriebszustand an die Perowskit-PV-Zelle (110) anzulegende Vorspannung durch eine Leistungselektronik (120) der PV-Einrichtung (1) bereitgestellt wird.

6. Verfahren nach Anspruch 3, **dadurch gekennzeichnet, dass** nach Beenden des Vorspannungs-Betriebszustandes zumindest ein Teil der von der Perowskit-PV-Zelle (110) bei Beleuchtung mit Licht L bereit gestellten Ausgangsspannung U1 zum Wiederaufladen des Energiespeichers (121, 121') verwendet wird.

7. Verfahren nach einem der vorhergehenden Ansprüche, **dadurch gekennzeichnet, dass** die Vorspannung im Vorspannungs-Betriebszustand
- konstant an die Perowskit-PV-Zelle (110) angelegt wird oder
- gepulst an der Perowskit-PV-Zelle (110) angelegt wird, wobei eine Folge von Vorspannungs-Pulsen derart angelegt wird, dass zwischen zwei aufeinander folgenden Vorspannungs-Pulsen jeweils keine Vorspannung anliegt, wobei zumindest zwischen einigen der Vorspannungs-Pulse ein die momentane Effizienz der Perowskit-PV-Zelle (110) repräsentierender Parameter gemessen wird und wobei für den Fall, dass die gemessene momentane Effizienz größer ist als ein vorgegebener Schwellwert, der Vorspannungs-Betriebszustand beendet wird, oder
- derart angelegt wird, dass eine vorgegebene Ladungsmenge in die Perowskit-PV-Zelle (110) fließt.

## Claims

1. Method for operating a PV device (1) having
- a perovskite PV cell (110) for converting light L which falls onto the perovskite PV cell (110) into an electrical output voltage U1 which can be tapped at an electrical connection (115) of the perovskite PV cell, as well as
- a control unit (130) for operating the PV device (1), wherein
- the control unit (130) is set up to monitor the PV device (1) with regard to the occurrence of a situation from a list of specific situations and to operate it in such a way that in the case of the specific situation occurring, a bias voltage operating state of the PV device (1) is triggered for a predetermined period, in which operating state an electrical bias voltage from an energy source (121, 121') is applied to a light-sensitive component (111) of the perovskite PV cell (110),
wherein the list of specific situations comprises:
- a start-up of the perovskite PV cell (110) and/or
- a lack of lighting of the perovskite PV cell (110), wherein a light sensor (116) for measuring lighting which falls onto the perovskite PV cell (110) is provided, wherein the light sensor (116) is connected to the control unit (130) in order to transmit sensor data to the control unit (130), and the control unit (130) is set up to evaluate the sensor data and to compare them with a lighting threshold value, wherein the specific situation of lack of lighting of the perovskite PV cell (110) is present when the lighting threshold value is fallen below, and/or
- a situation in which a measured variable which represents the instantaneous efficiency of the perovskite PV cell (110) falls below a predetermined efficiency threshold value of the perovskite PV cell (110), and/or
- a situation in which the instantaneous output voltage U1 of the perovskite PV cell (110) falls below a predetermined minimum output voltage U1min, wherein a voltmeter (120) for measuring the output voltage U1 of the perovskite PV cell (110) is provided, wherein the voltmeter (120) is connected to the control unit (130) in order to transmit voltage measurement data to the control unit (130), and the control unit (130) is set up to evaluate the voltage measurement data and to compare them with a voltage threshold value, wherein the specific situation of falling below the predetermined minimum output voltage U1 is present when the voltage threshold value is fallen below, and/or
- an expiration of a predetermined time span since the last occurrence of a specific situation,
**characterized in that** the control unit (130) is set up to operate the PV device (1) in such a way that in the case of the specific situation of lack of lighting of the perovskite PV cell (110) occurring, the bias voltage operating state is only triggered if the lighting measured value exceeds a further lighting threshold value BS' after falling below the lighting threshold value BS.

2. Method according to Claim 1, **characterized in that** a power electronics (120) of the PV device (1), which, at least in a normal operating state of the PV device (1), converts the electrical output voltage U1, which is provided by the perovskite PV cell (110) when lit with light L, into an output voltage U2 which can be tapped at an output of the power electronics (120), represents the energy source (121, 121').

3. Method according to either of Claims 1 and 2, **characterized in that** the energy source (121, 121') is an energy storage device from which the energy which is required for providing the bias voltage is obtained.

4. Method according to Claims 2 and 3, **characterized in that** the energy storage device (121) is incorporated into the power electronics (120) and in particular is designed as a capacitor or as a battery.

5. Method according to one of the preceding claims, **characterized in that** the bias voltage, which is to be applied to the perovskite PV cell (110) in the bias voltage operating state, is provided by a power electronics (120) of the PV device (1).

6. Method according to Claim 3, **characterized in that** at least one part of the output voltage U1, which is provided by the perovskite PV cell (110) when lit with light L, is used for recharging the energy storage device (121, 121') after terminating the bias voltage operating state.

7. Method according to one of the preceding claims, **characterized in that** the bias voltage in the bias voltage operating state
- is applied constantly to the perovskite PV cell (110) or
- is applied in a pulsed manner to the perovskite PV cell (110), wherein a sequence of bias voltage pulses is applied in such a way that no bias voltage is applied between two consecutive bias voltage pulses in each case, wherein a parameter which represents the instantaneous efficiency of the perovskite PV cell (110) is measured at least between some of the bias voltage pulses and wherein in the event that the measured instantaneous efficiency is greater than a predetermined threshold value, the bias voltage operating state is terminated, or
- is applied in such a way that a predetermined charge quantity flows into the perovskite PV cell (110).

## Revendications

1. Procédé pour faire fonctionner un dispositif (1) photovoltaïque comprenant
- une cellule (110) photovoltaïque à la perovskite pour la transformation de lumière L tombant sur la cellule (110) photovoltaïque à la perovskite en une tension U1 électrique de sortie, qui peut être prélevée sur une borne (115) électrique de la cellule photovoltaïque à la perovskite, ainsi que
- une unité (130) de commande pour faire fonctionner le dispositif (1) photovoltaïque, dans lequel
- l'unité (130) de commande est conçue pour contrôler l'entrée du dispositif (1) photovoltaïque dans une situation parmi une liste de situations définies et le faire fonctionner, de manière à déclencher, à l'entrée dans la situation définie pendant un laps de temps donné à l'avance, un état de fonctionnement en pré-tension du dispositif (1) photovoltaïque, dans lequel une pré-tension électrique d'une source (121, 121') d'énergie est appliquée à un composant (111) sensible à la lumière de la cellule (110) photovoltaïque à la perovskite,
dans lequel la liste de situations définies comprend :
- une mise en fonctionnement de la cellule (110) photovoltaïque à la perovskite et/ou
- un éclairage insuffisant de la cellule (110) photovoltaïque à la perovskite, un capteur (116) de lumière étant prévu pour mesurer un éclairage tombant sur la cellule (110) photovoltaïque à la perovskite, le capteur (116) de lumière étant relié à l'unité (130) de commande afin de transmettre des données de capteur à l'unité (130) de commande, et l'unité (130) de commande étant conçue pour analyser les données de capteur et les comparer à une valeur de seuil d'éclairage, dans lequel, si l'on passe en-dessous de la valeur de seuil d'éclairage, la situation définie d'éclairage insuffisant de la cellule (110) photovoltaïque à la perovskite est présente et/ou
- une situation, dans laquelle une grandeur de mesure représentant le rendement instantané de la cellule (110) photovoltaïque à la perovskite est inférieur à une valeur de seuil de rendement donnée à l'avance de la cellule (110) photovoltaïque à la perovskite, et/ou
- une situation, dans laquelle la tension U1 instantanée de sortie de la cellule (110) photovoltaïque à la perovskite est inférieure à une tension U1min minimum de sortie donnée à l'avance, dans laquelle un voltmètre (120) est prévu pour la mesure de la tension U1 de sortie de la cellule (110) photovoltaïque à la perovskite, dans lequel le voltmètre (120) est relié à l'unité (130) de commande afin de transmettre des données de mesure de tension à l'unité (130) de commande, et l'unité (130) de commande est conçue pour analyser les données de mesure de tension et les comparer à une valeur de seuil de tension, dans lequel, si l'on passe en-dessous de la valeur de seuil de tension, la situation définie de passage en-dessous de la tension U1 minimum de sortie donnée à l'avance est présente, et/ou
- l'écoulement d'un laps de temps donné à l'avance depuis la dernière entrée dans une situation définie,
**caractérisé en ce que** l'unité (130) de commande est conçue pour faire fonctionner le dispositif (1) photovoltaïque, de manière à ce que, à l'entrée dans la situation définie d'éclairage insuffisant de la cellule (110) photovoltaïque à la perovskite, on ne déclenche l'état de fonctionnement de pré-tension que si la valeur de mesure de l'éclairage, après que l'on est passé en-dessous de la valeur BS de seuil de l'éclairage, dépasse une autre valeur BS' de seuil de l'éclairage.

2. Procédé suivant la revendication 1, **caractérisé en ce qu'**une électronique (120) de puissance du dispositif (1) photovoltaïque, qui, au moins dans un état de fonctionnement normal du dispositif (1) photovoltaïque, transforme la tension U1 électrique de sortie, mise à disposition déjà par la cellule (110) photovoltaïque à la perovskite, lors de l'éclairage par de la lumière L, en une tension U2 de sortie pouvant être prélevée à une sortie de l'électronique (120) de puissance, représente la source (121, 121') d'énergie.

3. Procédé suivant l'une des revendications 1 ou 2, **caractérisé en ce que** la source (121, 121') d'énergie est un accumulateur d'énergie, dont l'énergie nécessaire à la mise à disposition de pré-tension est tirée.

4. Procédé suivant la revendication 2 et 3, **caractérisé en ce que** l'accumulateur (121) d'énergie est intégré à l'électronique (120) de puissance et est constitué notamment sous la forme d'un condensateur ou sous la forme d'une batterie.

5. Procédé suivant l'une des revendications précédentes, **caractérisé en ce que** la pré-tension appliquée à la cellule (110) photovoltaïque à la perovskite dans l'état de fonctionnement en pré-tension est mise à disposition du dispositif (1) photovoltaïque par une électronique (120) de puissance.

6. Procédé suivant la revendication 3, **caractérisé en ce qu'**après qu'il a été mis fin à l'état de fonctionnement en pré-tension, on utilise au moins une partie de la tension U1 de sortie mise à disposition par la cellule (110) photovoltaïque à la perovskite lors de l'éclairage par de la lumière L pour recharger l'accumulateur (121, 121') d'énergie.

7. Procédé suivant l'une des revendications précédentes, **caractérisé en ce que** la pré-tension dans l'état de fonctionnement en pré-tension
- est appliquée de manière constante à la cellule (110) photovoltaïque à la perovskite ou
- est appliquée de manière pulsée à la cellule (110) photovoltaïque à la perovskite, un train d'impulsions de pré-tension étant appliqué de manière à ne pas appliquer respectivement de pré-tension entre deux impulsions de pré-tension successives, dans lequel, au moins entre certaines des impulsions de pré-tension, on mesure un paramètre représentant le rendement instantané de la cellule (110) photovoltaïque à la perovskite, et dans lequel, dans le cas où le rendement instantané mesuré est plus grand qu'une valeur de seuil donnée à l'avance, on met fin à l'état de fonctionnement en pré-tension, ou
- est appliquée de manière à ce qu'une quantité de charge donnée à l'avance passe dans la cellule (110) photovoltaïque à la perovskite.
